Europäisches Patentamt

European Patent Office

Office européen des brevets

(19)

(11) Veröffentlichungsnummer: **0 254 948**
**A2**

(12) # EUROPÄISCHE PATENTANMELDUNG

(21) Anmeldenummer: **87110106.9**

(22) Anmeldetag: **14.07.87**

(51) Int. Cl.⁴: **H01L 21/84**

(30) Priorität: **25.07.86 DE 3625263**

(43) Veröffentlichungstag der Anmeldung:
**03.02.88 Patentblatt 88/05**

(84) Benannte Vertragsstaaten:
**BE DE FR GB IT NL SE**

(71) Anmelder: **BASF Aktiengesellschaft
Carl-Bosch-Strasse 38
D-6700 Ludwigshafen(DE)**

(72) Erfinder: **Portugall, Michael, Dr.
Raiffeisenstrasse 7
D-6706 Wachenheim(DE)**
Erfinder: **Sterzel, Hans-Josef, Dr.
Wasgauring 3
D-6701 Dannstadt-Schauernheim(DE)**
Erfinder: **Blinne, Gerd, Dr.
Im Woogtal 7
D-6719 Bobenheim(DE)**
Erfinder: **Vondenhagen, Heinz-Dieter
Koenigsberger Strasse 9
D-6710 Frankenthal(DE)**
Erfinder: **Seiler, Erhard, Dr.
Erpolzheimer Strasse 1
D-6700 Ludwigshafen(DE)**
Erfinder: **Schmidt, Hans-Friedrich, Dr.
Graf-Tattenbach-Weg 3
D-8196 Eurasburg(DE)**
Erfinder: **Von Tomkewitsch,Sybille
Ascheringer Weg 4
D-8134 Pöcking(DE)**

(54) **Mikroelektronische Bauelemente sowie Dickschicht-Hybridschaltungen.**

(57) Mikroelektronische Bauelemente sowie Dickschicht-Hybridschaltungen, bei denen die Mehrschichtensubstrate der mikroelektronischen Bauelemente sowie die Substrate der Dickschicht-Hybridschaltungen unter Verwendung von thermoplastisch verarbeitbaren flüssigkristallinen Polymeren hergestellt worden sind.

EP 0 254 948 A2

## Mikroelektronische Bauelemente sowie Dickschicht-Hybridschaltungen

Die Erfindung betrifft mikroelektronische Bauelemente sowie Dickschicht-Hybridschaltungen, die sich gegenüber dem Stand der Technik durch eine niedrigere Rate der temporären Fehler und eine erhöhte Signalgeschwindigkeit auszeichnen und deren Mehrschichtensubstrate bzw. Substrate einfach herstellbar und dimensionsstabil sind.

Sogenannte mikroelektronische Bauelemente enthalten als wesentlichen Bestandteil einen sogenannten "silicon chip" - ein üblicherweise aus Silizium bestehendes Plättchen, auf dem die eigentlichen funktionalen Stromkreise in einer zweidimensionalen Schaltanordnung aufgebracht sind. Der "silicon chip" wird allgemein auch als "integrierter Schaltkreis" bezeichnet.

Stets müssen Stromkreise unterschiedlicher Funktionen eines integrierten Schaltkreises noch untereinander in geeigneter Weise verbunden bzw. integriert werden, was aber in zwei Dimensionen oft nicht mehr möglich ist. Aus diesem Grunde und aus Gründen der mechanischen Stabilität sowie der Notwendigkeit, die mikroskopisch kleinen Endstellen der Leiterbahnen mit denen anderer integrierter Schaltkreise und/oder größer dimensionierter Schaltungen - z.B. Dickschicht-Hybridschaltungen - zu verbinden, ist es notwendig den integrierten Schaltkreis auf einem Träger aufzubringen, der die für die weitere Verschaltung und die Außenverbindung notwendigen Leiterbahnen in geeigneter Schaltanordnungen enthält. Ein solcher Träger wird als "Substrat" bezeichnet.

Wegen der inzwischen bei den integrierten Schaltkreisen erzielten Schaltungsdichte, reicht ein Substrat oftmals nicht mehr aus, sondern es werden mehrere übereinandergeschichtete und untereinander verschaltete Substrate notwendig, um die obengenannten Funktionen zu erfüllen. Diese Substrate werden als "multilayer"-Substrate oder "Mehrschichtensubstrate" bezeichnet.

Diese Mehrschichtensubstrate wiederum sind Bestandteil des sogenannten "Package" für einen integrierten Schaltkreis. Unter "Package" versteht man ein in geeigneter Weise geformtes, aus unterschiedlichen Teilen zusammengesetztes Bauteil, dessen Aufgabe es ist, den integrierten Schaltkreis räumlich zu verankern, mit anderen integrierten Schaltkreisen und/oder mit sehr viel größeren Schalteinheiten - z.B. Dickschicht-Hybridschaltungen - zu verbinden und gegebenenfalls gegen Umwelteinflüsse hermetisch abzuschirmen.

Die Kombination aus integriertem Schaltkreis und Package ist als mikroelektronisches Bauelement zu bezeichnen.

Dickschicht-Hybridschaltungen sind elektrische Bauelemente, welche im wesentlichen aus einem Substrat mit darauf in geeigneter Weise aufgebrachten Leiterbahnen sowie passiven und aktiven elektrischen Bauelementen bestehen und durch eine äußere Umhüllung vor Umwelteinflüssen geschützt sind (vgl. A. Inzenhofer, "Dickschicht-Hybridschaltungen, neue Fertigungstechnik für die Industrieelektronik", Technik Heute, 1985, Seiten 24 bis 32). Typische aktive elektrische Bauelemente von Dickschicht-Hybridschaltungen sind die vorstehend definierten mikroelektronischen Bauelemente.

Stand der Technik ist es, die Mehrschichtensubstrate der integrierten Schaltkreise unter Verwendung ungesinterter keramischer Folien von ca. 200 bis 400 $\mu$m Dicke herzustellen. Diese keramischen Folien müssen nach dem Aufbringen der Leiterbahnen durch Siebdruck mit Metallpasten und dem Übereinanderstapeln ausgebrannt und gesintert werden (vgl. Mehrschichtenkeramik-Technologie für das "Thermal Conduction Module", Berichte der deutschen keramischen Gesellschaft, Heft 7, 1981, Seiten 553 bis 557). Dieses Verfahren ist aber sehr aufwendig und mit einem erheblichen Zeitaufwand und Ausschuß behaftet. Hinzu kommt noch, daß der erhebliche hohe Gehalt an $\alpha$-Strahlern in den keramischen Materialien temporäre Fehler in den integrierten Schaltkreisen hervorruft: Die in das Halbleitermaterial eindringenden $\alpha$-Teilchen erzeugen Elektronen-Loch-Paare, die erst nach einer gewissen Zeit ausheilen und bis dahin den integrierten Schaltkreis mehr oder weniger in seiner Funktion stören. Es hat deshalb nicht an Versuchen gefehlt, die Keramikmaterialien im Package durch Thermoplaste oder Reaktivharze wie Silikon-oder Epoxiharze zu ersetzen (vgl. A.G. Saunders, "Plastics in integrated circuit packaging", Shell Polymers, Band 9, Heft 1, 1985, Seite 12 bis 15). Diese weisen jedoch allgemein Nachteile wie Wasser-und Gasdurchlässigkeit auf. Hinzu kommt noch, daß bei der Verwendung von Reaktivharzen eine Nachhärtung notwendig ist, wohingegen es bei der Anwendung von Thermoplasten oftmals zum Verbiegen oder zur völligen Zerstörung der vom integrierten Schaltkreis ausgehenden feinen Verbindungsdrähte durch die Thermoplastschmelze beim Spritzguß kommt.

Gleiches gilt für Dickschicht-Hybridschaltungen, deren Substrate bekanntermaßen unter Verwendung von Keramik oder von emailliertem Stahl hergestellt werden (vgl. A. Inzenhofer, "Dickschicht-Hybridschaltungen, neue Fertigungstechnik für die Industrieelektronik", Technik Heute, 1985, Seiten 24 bis 32). Auch die Herstellung solcher Substrate erfordert einen hohen technischen und zeitlichen Aufwand, und die Rate der temporären Fehler der Dickschicht-Hybridschaltungen ist hoch. Außerdem war es bisher noch nicht möglich gewesen, die Substrate aus Keramik oder aus Stahl durch solche aus Kunststoffen - z.B. aus Epoxiharzen, wie sie für die Herstellung herkömmlicher Leiterplatten üblicherweise verwendet werden - zu ersetzen.

Es ist ferner aus der EP-A-0 135 310 bekannt, mikroelektronische und elektrische Bauelemente mit thermoplastisch verarbeitbaren flüssigkristallinen Polymeren, welche anorganische Füllstoffe enthalten, zu umhüllen.

Aufgabe der vorliegenden Erfindung war es, mikroelektronische Bauelemente sowie Dickschicht-Hybridschaltungen zu finden, die die vorstehend geschilderten Nachteile nicht mehr zeigen und die darüber hinaus eine im Vergleich zum Stand der Technik erhöhte Signalgeschwindigkeit und eine niedrigere Rate der temporären Fehler aufweisen, wobei die Mehrschichtensubstrate der mikroelektronischen Bauelemente sowie die Substrate der Dickschicht-Hybridschaltungen einfach herzustellen und dimensionsstabil sein sollen.

Demgemäß wurden mikroelektronische Bauelemente sowie Dickschicht-Hybridschaltungen gefunden, bei denen die Mehrschichtensubstrate der mikroelektronischen Bauteile ·sowie die Substrate der Dickschicht-Hybridschaltungen unter Verwendung von thermoplastisch verarbeitbaren flüssigkristallinen Polymeren hergestellt worden sind.

Im Rahmen der Erfindung bezeichnet der Begriff "thermoplastisch verarbeitbares flüssigkristallines Polymeres" ein Polymer, das als Schmelze anisotrope optische Eigenschaften aufweist, die mit Hilfe des in DE-AS 25 20 819 in Spalte 20 bis 24 beschriebenen thermooptischen Tests durch Polarisationsmikroskopie an sehr dünnen, geschmolzenen Polymerschichten nachgewiesen werden können. Dabei zeigen Polymerschmelzen mit isotropen optischen Eigenschaften bei gekreuzten Polarisatoren im wesentlichen eine Löschung des im Test verwendeten Lichts, während optisch anisotrope Polymerschmelzen doppelbrechende Texturen zeigen, die flüssigkristallinen Phasen zugeordnet werden können.

Geeignete erfindungsgemäß für die Herstellung der Mehrschichtensubstrate sowie der Substrate anzuwendende thermoplastisch verarbeitbare flüssigkristalline Polymere bilden flüssigkristalline Phasen unterhalb 400°C, vorzugsweise unterhalb 360°C. Gut geeignet sind thermoplastisch verarbeitbare flüssigkristalline voll-oder teilaromatische Polykondensate, wobei durch den Begriff "vollaromatisch" ausgedrückt wird, daß jede im Polykondensat vorkommende Monomereinheit wenigstens einen aromatischen Ring für den Aufbau der Polymerkette zur Verfügung stellt, wohingegen der Begriff "teilaromatisch" darauf hinweist, daß ein Teil der im Polykondensat vorhandenen Monomereinheiten keine aromatische, sondern z.B. aliphatische oder cycloaliphatische Gruppen darstellt.

Solche Polykondensate lassen sich in bekannter Weise aus entsprechenden aromatischen und gegebenenfalls aliphatischen bzw. cycloaliphatischen Verbindungen, welche jeweils mindestens zwei zu Kondensationsreaktionen befähigte funktionelle Gruppen enthalten, herstellen, wobei in diesen Verbindungen diese funktionellen Gruppen stets so mit den Grundgerüsten der Verbindungen verknüpft sind, daß bei den Polykondensationsreaktionen überwiegend weitgehend lineare oder angenähert lineare Polykondensate entstehen. Von diesen Verbindungen sind die aromatischen bevorzugt.

Beispiele geeigneter, zu Kondensationsreaktionen befähigter funktioneller Gruppen von bevorzugten Verbindungen sind: Hydroxy-, Acyloxy-, Hydroxylat-, Thiolo-, Thiolat-, Amino-oder Acylaminogruppen einerseits und Carboxy-, Carboxylat-, Carbonsäureanhydrid-, Carboxylester-oder Carbonylhalogenidgruppen oder Halogenatome andererseits, die miteinander unter Bildung von Ester-, Thioester, Carbonat-, Amid-, Imid-, Ether-oder Thioethergruppen reagieren können, wobei funktionelle Gruppen, die unter der Bildung von Estergruppen miteinander reagieren, bevorzugt sind.

Neben diesen funktionellen Gruppen können die Verbindungen Gruppen enthalten, die nicht oder nicht mehr zu der im Einzelfall durchzuführenden Kondensationsreaktion befähigt sind, wie Halogenatome oder Alkyl-, Alkylen-, Aryl-, Carbonyl-, Sulfon-, Ether-, Imid-oder Pseudohalogenidgruppen.

Beispiele für geeignete Grundgerüste von bevorzugten Verbindungen, die kondensierbare funktionelle Gruppen enthalten, sind einkernige Aromaten wie Benzol; lineare, direkt miteinander verknüpfte mehrkernige Aromten wie Biphenyl, Terphenyl oder Quaterphenyl; lineare kata-anellierte Aromaten wie Naphthalin oder Anthracen oder lineare, indirekt miteinander verknüpfte mehrkernige Aromaten wie Diphenylsulfon, Diphenylether, Triphenylether, 2,2-Diphenylpropan, Diphenylketon, Bisphenoxiethan-1,2 oder Anthrachinon.

Beispiele für bevorzugte, bei der Herstellung der Polykondensate verwendete aromatische Verbindungen sind demnach Hydrochinon, 2,6-Dihydroxinaphthalin, 2,7-Dihydroxinaphthalin, 4,4'-Dihydroxibiphenyl, Bis-(4-hydroxiphenyl)sulfon, Bis-(4-hyroxiphenyl)keton, Bis-(4-hydroxiphenyl)propan-2,2, Bis-(4-hydroxiphenyl)ether, Bis-(4-hydroxiphenoxi)ethan-1,2, 2,6-Dihydroxianthracen oder 2,6-Dihydroxianthrachinon einerseits und Terephthalsäure und/oder Isophthalsäure sowie gegebenenfalls p-Hydroxibenzoesäure andererseits.

Mithin handelt es sich bei den erindungsgemäß besonders gut geeigneten thermoplastisch verarbeitbaren flüssigkristallinen Polymeren um weitgehend lineare oder angenähert lineare vollaromatische Polykondensate wie Polyester, Polyesteramide, Polyesterether, Polyestercarbonate, Polyesteramidimide oder Polyesterimide, von denen Polyester, welche aus den bevorzugten Verbindungen hergestellt worden sind, besonders bevorzugt zur Anwendung gelangen.

Polyester dieser Art und ihre Herstellung sind beispielsweise aus der EP-A-01 39 303 bekannt.

Die thermoplastisch verarbeitbaren flüssigkristallinen Polymeren können geeignete feinteilige, homogen dispergierte, anorganische Füllstoffe enthalten. Hierfür kommen z.B. amorphes Siliziumdioxid, Quarzmehl, Talkum, Aluminiumoxid, oder Cordierit in Betracht. Im allgemeinen weisen diese anorganischen Füllstoffe eine mittlere Teilchengröße von 0,5 bis 50 $\mu$m auf, wobei mindestens 99 % der Teilchen eine Teilchengröße von weniger als 100 $\mu$m aufweisen. Besonders gut geeignet sind dabei Teilchen, welche kugelförmig oder angenähert kugelförmig sind. Die Teilchen können mit üblichen und bekannten Materialien wie beispielsweise $\gamma$-Aminopropyltriethoxisilan oder $\gamma$-Glycidoxipropyltrimethoxisilan beschichtet werden, um ihre Dispergierung in den flüssigkristallinen Polymeren zu erleichtern. Im allgemeinen können diese anorganischen Füllstoffe in den flüssigkristallinen Polymeren in einer Menge von 10 bis 70, vorzugsweise 20 bis 60 und insbesondere 30 bis 55 Gew.%, bezogen auf die Polymere, enthalten sein.

Darüber hinaus können die flüssigkristallinen Polymere noch Farbstoffe, klebrig machende Stoffe, Antioxidantien, Gleitmittel, Formtrennmittel, Weichmacher und andere Additive enthalten, welche allerdings die anwendungstechnischen Eigenschaften der Polymeren nicht verschlechtern und die Funktion der mikroelektronischen Bauelemente und der Dickschicht-Hybridschaltungen nicht beeinträchtigen dürfen.

Für die Herstellung der erfindungsgemäßen mikroelektronischen Bauelemente werden zunäct unter Verwendung der thermoplastisch verarbeitbaren flüssigkristallinen Polymere Mehrschichtensubstrate hergestellt.

Dazu werden aus den thermoplastisch verarbeitbaren flüssigkristallinen Polymeren durch Extrusion und nachgeschaltetem biaxialem Verstrecken oder durch Extrusion und nachgeschaltetem Folienblasen 10 bis 50, vorzugsweise 20 bis 40 $\mu$m dicke Folien hergestellt, wobei die genannten Methoden übliche und bekannte Verfahrensweisen der Polymerverarbeitung sind, die keine methodischen Besonderheiten aufweisen und deren Verfahrensparameter durch einfache Vorversuche ermittelt werden können.

Aus den in dieser Weise hergestellten Folien aus thermoplastisch verarbeitbaren flüssigkristallinen Polymeren werden rechteckige, vorzugsweise quadratische Folienstücke einer geeigneten Kantenlänge - üblich sind 5 cm - ausgestanzt. Diese Folienstücke werden durch Ausstanzen oder durch Bestrahlen mit Laserlicht mit den für die spätere dreidimensionale Verschaltung notwendigen Bohrungen versehen, wobei der Bohrlochdurchmesser im allgemeinen bei etwa 150 $\mu$m liegt. Anschließend werden die dem Schaltplan gemäßen Leiterbahnen durch Siebdruck mit Metallpasten, beispielsweise mit durch Silberpulver hochgefüllten Epoxiharzen, aufgebracht. Dabei werden die Bohrungen mit der Metallpaste ausgefüllt; diese Stellen dienen später der gegenseitigen elektrischen Kontaktierung der Schaltungen auf unterschiedlichen Folienstücken.

Die mit den Leiterbahnen und Kontaktstellen versehenen Folienstücke aus thermoplastisch verarbeitbaren flüssigkristallinen Polymeren, die auch als "Einzelschichtsubstrate" angesehen werden können, werden dann in der dem dreidimensionalen Schaltplan gemäßen Reihenfolge übereinandergestapelt, in dieser Anordnung, z.B. in einem Rahmen, exakt fixiert und anschließend bei erhöhter Temperatur, vorzugsweise oberhalb der Glastemperatur $T_G$ des jeweils verwendeten thermoplastisch verarbeitbaren flüssigkristallinen Polymeren, unter Druck haftfest miteinander zu einem Mehrschichtensubstrat verbunden. Vor dem Bedrucken der Folienstücke und/oder dem Verbinden der Einzelschichtsubstrate zu einem Mehrschichtensubstrat, kann die Oberfläche dieser Teile durch Ätzen mittels Ionenstrahl-oder Plasmaverfahren in ihrer Haftfähigkeit verbessert werden.

In der Folge wird der integrierte Schaltkreis auf das Mehrschichtensubstrat, welches unter Verwendung der thermoplastisch verarbeitbaren flüssigkristallinen Polymeren hergestellt worden ist, aufgebracht und haftfest damit verbunden. Anschließend wird der integrierte Schaltkreis mit dem Mehrschichtensubstrat in einer dem Schaltplan gemäßen Weise verschaltet.

Ein solches Teil, bestehend aus integriertem Schaltkreis und Mehrschichtensubstrat, oder auch mehrere dieser Teile werden dann über das oder die Mehrschichtensubstrate mit den übrigen Bestandteilen des Package mechanisch verbunden und in einer dem Schaltplan gemäßen Weise verschaltet. Es resultiert das erfindungsgemäße mikroelektronische Bauelement das ein oder mehrere Mehrschichtensubstrate, welche unter Verwendung thermoplastisch verarbeitbarer flüssigkristalliner Polymere hergestellt worden sind, enthält. Das mikroelektronische Bauelement kann dann nach dem aus der EP-A-0 135 310 bekannten Verfahren umhüllt werden.

Für die Herstellung der erfindungsgemäßen Dickschicht-Hybridschaltungen werden zunächst unter Verwendung der thermoplastisch verarbeitbaren flüssigkristallinen Polymeren Substrate hergestellt.

Dazu werden aus den thermoplastisch verarbeitbaren flüssigkristallinen Polymeren durch Spritzguß oder Extrusion Platten oder Plattenbahnen geformt, die - als solche oder nach Zuschnitt - senkrecht zur Guß-oder Extrusionsrichtung kalandriert werden. Dabei sind die genannten Methoden übliche und bekannte Verfahrensweisen der Polymerverarbeitung, die keine methodischen Besonderheiten aufweisen, und deren Verfahrensparameter durch einfache Vorversuche ermittelt werden können. Im allgemeinen sind solche Platten oder Plattenbahnen nach dem Spritzguß oder der Extrusion etwa etwa 0,5 bis 1,5 mm dick. Durch das Kalandrieren verringert sich ihre Dicke und liegt dann im Bereich der Walzenspaltöffnung der Kalanderwalzen. Die Platten oder Plattenbahnen werden anschließend zu rechteckigen, vorzugsweise quadratischen Plattenstücken geeigneter Abmessungen, beispielsweise 2 × 2 inch, zerteilt, wobei die Randbereiche der Platten oder Plattenbahnen verworfen werden. Diese Plattenstücke aus thermoplastisch verarbeitbaren flüssigkristallinen Polymeren können dann auch noch in geeigneter Weise mit schaltplangemäßen Bohrungen versehen werden. Diese Bohrungen, die unterschiedliche Durchmesser aufweisen können, dienen später der Aufnahme von Steckkontakten elektrischer Bauelemente und Stromquellen.

Auf diese Plattenstücke werden durch Siebdruck mit Metallpasten die dem Schaltplan gemäßen Leiterbahnen in einer Dicke von im allgemeinen 5 bis 25 µm aufgebracht und mit Hilfe einer geeigneten Temperaturbehandlung eingebrannt, d.h. auf den Plattenstücken fixiert. Es resultieren die Substrate der erfindungsgemäßen Dickschicht-Hybridschaltungen.

Durch den Einbau von elektrischen Bauelementen, welche nicht mittels der Siebdrucktechnik aufgebracht werden können, wie Außenanschlüsse, Dioden, Transistoren, nichtlineare Widerstände, Kondensatoren hoher Kapazität und/oder mikroelektronische Bauelemente, mittels Anlöten oder Einstecken in vorhandene Lockontakte werden die erfindungsgemäßen Dickschicht-Hybridschaltungen vervollständigt.

Anschließend können diese erfindungsgemäßen Dickschicht-Hybridschaltungen, deren Substrate unter Verwendung thermoplastisch verarbeitbarer flüssigkristalliner Polymerer hergestellt worden sind, vor dem Einschluß in eine Umhüllung mit Reaktivharzen wie Silikonharzen in geeigneter Weise vergossen werden oder nach dem aus der EP-A-0 135 310 bekannten Verfahren umhüllt werden.

Die erfindungsgemäßen mikroelektronischen Bauelemente und die erfindungsgemäßen Dickschicht-Hybridschaltungen zeichnen sich gegenüber dem vom Stand der Technik her bekannten durch zahlreiche überraschende Vorteile aus: So ist ihre Signalgeschwindigkeit deutlich höher und ihre Rate der temporären Fehler erheblich niedriger, und ihre Funktionsfähigkeit wird selbst durch starke Temperaturschwankungen nicht beeinträchtigt. Sie lassen sich einfach unnd rasch herstellen, wobei die Ausschußrate sehr gering ist, und ihre wesentlichen Bauteile auf der Basis thermoplastisch verarbeitbarer flüssigkristalliner Polymerer müssen nicht nachgehärtet werden und weisen keine Verzugsneigung auf. Außerdem sind diese Bauteile hitzestabil genug, um die Temperaturen der Lötbäder für die für die Lötvorgänge notwendigen Zeiträume ohne Beschädigung auszuhalten. Von besonderem Vorteil ist, daß das Einbrennen der Metallpasten bei vergleichsweise niedrigen Temperaturen durchgeführt werden kann.

Beispiele

Beispiel 1

Herstellung von Dickschicht-Hybridschaltungen

a) Herstellung eines vollaromatischen thermoplastisch verarbeitbaren flüssigkristallinen Polyesters.

Herstellvorschrift:

2,75 kg (≙ 25 mol) Hydrochinon, 4,65 kg (≙ 25 mol) 4,4'-Dihydroxibiphenyl, 8 kg (≙ 50 mol) 2,7-Dihydroxinaphthalin, 17,25 kg (≙ 125 mol) 4-Hydroxibenzoesäure, 16,6 kg (≙ 100 mol) Terephthalsäure und 87,72 kg (≙ 860 mol) Essigsäureanhydrid wurden unter einer Stickstoffatmosphäre 30 Minuten bei 130°C gerührt und anschließend auf 150°C erhitzt. Danach wurde die Temperatur innerhalb von 2,3 Stunden auf 290°C gesteigert. Dabei wurden 93 kg Destillat erhalten.

Anschließend wurde bei 290°C über einen Zeitraum von 55 Minuten der Druck auf 5 mbar reduziert und dann weitere 45 Minuten bei 290°C gerührt. Man erhielt eine hochviskose fadenbildende Schmelze. Die Polyesterschmelze und der erkaltete Polyester zeigten eine perlmuttartigen Glanz. Die Glastemperatur $T_G$ wurde durch Differentialkalorimetrie (DSC) bestimmt und betrug 121°C. Die inhärente Viskosität [$\eta$] des Polyesters nach 14stündiger Lagerung bei 200°C und einem Druck von 20 mbar war 3,5 dl/g (gemessen an einer 0,1 gew.%igen Lösung in Pentafluorphenol bei 60°C). Bei 290°C zeigte der Polyester im Polarisationsmikroskop flüssigkristalline Eigenschaften.

b) Herstellung der Schaltungen unter Verwendung des Polyesters

Der Polyester wurde in einem Extruder bei 300°C aufgeschmolzen und durch eine Breitschlitzdüse so ausgetragen, daß eine 1,25 mm dicke und 400 mm breite Plattenbahn resultierte. Diese Plattenbahn wurde in quadratische Platten der Abmessung 400 × 400 mm zurechtgeschnitten und diese dann bei einer Walzentemperatur von 170 bis 180°C, einer Walzenspaltöffnung von 0,5 mm und einer Vorschubgeschwindigkeit von 25 mm/Sek. senkrecht zur ursprünglichen Extrusionsrichtung kalandriert. Die kalandrierten 0,62 mm dicken Platten wurden in Plattenstücke der Abmessungen 2 × 2 inch zurechtgesägt, wobei die Randstreifen der kalandrierten Platten in der Kalandrierrichtung auf einer Breite von je ca. 5 cm und in der ursprünglichen Extrusionsrichtung auf einer Breite von je ca. 10 cm verworfen wurden.

Die Plattenstücke wurden mit den notwendigen Bohrungen versehen unnd in einer Präzisionssiebdruckmaschine mit Leiterbahnen aus Silberpaste (90 % Silberpulver in Epoxiharz) bedruckt. Anschließend wurden die Leiterbahnen bei 200°C fixiert.

Auf diese Substrate wurden weitere elektrische Bauelemente und die Anschlußkontakte aufgesteckt oder angelötet, wobei insbesondere die nach Beispiel 2 hergestellten mikroelektronischen Bauelemente zur Anwendung kamen. Anschließend wurden die so erhaltenen erfindungsgemäßen Dickschicht-Hybridschaltungen einer elektrischen Funktionsprüfung unterzogen. Diese ergab, daß erfindungsgemäße Schaltungen im Vergleich zu üblichen eine besonders niedrige Rate der temporären Fehler und eine ausgesprochen hohe Signalgeschwindigkeit aufwiesen. Außerdem zeigten sie keine Verzugsneigung, und Temperaturschwankungen hatten keinen Einfluß auf ihre Funktionsfähigkeit.

Beispiel 2

Herstellung eines mikroelektronischen Bauelements

Der nach Beispiel 1a hergestellte Polyester wurde bei 320°C auf einem Extruder aufgeschmolzen und über einen Folienblaskopf mit einer Ringdüse von 127 mm Durchmesser und einer Spaltöffnung von 0,6 mm ausgetragen. Die Abzugsgeschwindigkeit betrug 5 m/Min., der Massedurchsatz 44 kg/h. Die Luftzufuhr war dabei so geregelt, daß sich ein Aufblasverhältnis von 1:2,5 ergab. Die Wandstärke der resultierenden Schlauchfolie war 0,04 mm.

Aus dieser Schlauchfolie wurden quadratische Folienstücke von 5 cm Kantenlänge ausgestanzt. Die Folienstücke wurden mit den nach dem Schaltplan erforderlichen Bohrungen von 150 μm Durchmesser versehen, welche später die elektrisch leitenden Verbindungen zu benachbarten Lagen innerhalb eines Mehrschichtensubstrats aufnahmen. Danach wurden die Leiterbahnen durch Präzisionssiebdruck mit Silberpaste (90 % Silberpulver in Epoxiharz) aufgebracht, wobei die aufgedruckten Leiterbahnen auf den so erhaltenen "Einzelschichtsubstraten" 75 μm breit und 5 μm dick waren. Die Endpunkte der Leiterbahnen des untersten "Einzelschichtsubstrates" wurden dann noch von seiner Rückseite aus mit feinen Anschlußdrähten, sogenannte Anschlußfahnen, verbunden.

Jeweils zwanzig verschieden bedruckte "Einzelschichtsubstrate" wurden - dem Gesamtschaltplan der Mehrschichtensubstrate gemäß -zur genauen Führung in einen Rahmen gesetzt und in einer Presse bei 230°C und einem Druck von 25 kp/cm² innerhalb von 20 Minuten miteinander zu Mehrschichtensubstraten verbunden, wobei der Binder (Epoxiharz) der Silberpaste, aus der die Leiterbahnen hergestellt worden waren, aushärtete.

Die elektrische Funktionsprüfung ergab, daß alle in dieser Weise hergestellten Mehrschichtensubstrate voll funktionsfähig waren, d.h. es war in den Substraten weder zu Kurzschlüssen noch zu einer Beschädigung der Anschlußdrähte gekommen.

Auf diese Mehrschichtensubstrate wurden in der Folge integrierte Schaltkreise aufgebracht. Nach der elektrischen Funktionsprüfung, die eine im Vergleich zum Stand der Technik deutlich erhöhte Signalgeschwindigkeit und eine erheblich niedrigere Rate der temporären Fehler ergab, wurden die Bauteile aus integriertem Schaltkreis und Mehrschichtensubstrat über die Mehrschichtensubstrate mit dem Rest der Packages mechanisch verbunden und elektrisch verschaltet. Es resultierten die erfindungsgemäßen mikroelektronischen Bauelemente.

Ihre elektrische Funktionsprüfung ergab, daß die Ausschußrate dieser einfachen und schnellen Herstellweise weit unterhalb der von Verfahren des Standes der Technik lag, wobei die erfindungsgemäßen Bauelemente die Signalgeschwindigkeit herkömmlicher Bauelemente weit übertrafen und deren Rate der temporären Fehler erheblich unterschritten. Selbst starke Temperaturschwankungen hatten keinen Einfluß auf ihre Funktionsfähigkeit.

## Ansprüche

1. Mikroelektronische Bauelemente sowie Dickschicht-Hybridschaltungen, dadurch gekennzeichnet , daß die Mehrschichtensubstrate in den mikroelektronischen Bauelementen sowie die Substrate der Dickschicht-Hybridschaltungen unter Verwendung von thermoplastisch verarbeitbaren flüssigkristallinen Polymeren hergestellt worden sind.

2. Mikroelektronische Bauelemente sowie Dickschicht-Hybridschaltungen nach Anspruch 1, dadurch gekennzeichnet , daß die Mehrschichtensubstrate in den mikroelektronischen Bauelementen sowie die Substrate der Dickschicht-Hybridschaltungen unter Verwendung von thermoplastisch verarbeitbaren flüssigkristallinen vollaromatischen weitgehend linearen oder angenähert linearen Polyestern hergestellt worden sind.

3. Mikroelektronische Bauelemente sowie Dickschicht-Hybrid-Schaltungen nach Anspruch 1, dadurch gekennzeichnet , daß die thermoplastisch verarbeitbaren flüssigkristallinen Polymeren, bezogen auf ihre Menge, 10 bis 70 Gew.%, an feinteiligen, homogen dispergierten, anorganischen Füllstoffen enthalten.

4. Mikroelektronische Bauelemente sowie Dickschicht-Hybrid-Schaltungen nach Anspruch 2, dadurch gekennzeichnet, daß die thermoplastisch verarbeitbaren flüssigkristallinen vollaromatischen weitgehend linearen oder angenähert linearen Polyester, bezogen auf ihre Menge, 10 bis 70 Gew.%, an feinteiligen, homogen dispergierten, anorganischen Füllstoffen enthalten.